(19) Europäisches Patentamt

European Patent Office

Office européen des brevets

(11) Numéro de publication: **0 180 172**
**B1**

(12) **FASCICULE DE BREVET EUROPEEN**

(45) Date de publication du fascicule du brevet:
**28.12.88**

(21) Numéro de dépôt: **85113662.2**

(22) Date de dépôt: **26.10.85**

(51) Int. Cl.⁴: **H 05 K 13/00**

(54) Procédé pour l'assemblage et la connexion de circuits intégrés à des unités de circuit et machine pour sa mise en oeuvre.

(30) Priorité: **30.10.84 FR 8416748**

(43) Date de publication de la demande:
**07.05.86 Bulletin 86/19**

(45) Mention de la délivrance du brevet:
**28.12.88 Bulletin 88/52**

(84) Etats contractants désignés:
**CH DE GB LI**

(56) Documents cités:
**CA-A- 915 318**
**US-A- 3 698 620**
**US-A- 3 724 068**

(73) Titulaire: **Eta SA Fabriques d'Ebauches,
Schild-Rust-Strasse 17, CH-2540 Granges (CH)**

(72) Inventeur: **Alain, Juan, Chemin des Esserts 30,
CH-2054 Chézard (CH)**

(74) Mandataire: **Caron, Gérard et al, ICB Ingénieurs
Conseils en Brevets SA Passage Max. Meuron 6,
CH-2001 Neuchâtel (CH)**

ACTORUM AG

## Description

La présente invention est relative à un procédé pour l'assemblage et la connexion de circuits intégrés à des unités de circuit. Plus particulièrement, l'invention concerne un tel procédé au cours duquel les plots de connexion situés sur la périphérie de l'une des faces du circuit intégré sont réunis thermiquement à des bornes des unités de circuit selon la technique qui est connue sous la dénomination anglo-saxonne de «I.L.B.» pour «Inner Lead Bonding» (connexion par conducteurs intérieurs). Il est à noter que dans le présent mémoire, on entend par unité de circuit, tout ensemble de conducteurs dans lequel le circuit intégré doit être inséré, cet ensemble pouvant lui-même être pourvu déjà d'un ou de plusieurs composants électriques ou électroniques.

Un procédé selon le préambule de la revendication 1, et une machine selon le préambule de la revendication 4, sont connus du document US-A-3 724 068.

Pour mettre en œuvre la technique «I.L.B.», on utilise habituellement un ruban se présentant sous la forme d'un film cinématographique portant disposée selon une rangée longitudinale une série d'unités de circuit auxquelles les circuits intégrés doivent respectivement être réunis par alliage ou soudage des plots et des bornes. Le film est entraîné pas-à-pas dans le poste de soudage et l'opération de soudage a lieu par application de l'outil chauffé (ou thermode) sur les plots et les bornes respectivement superposés, le circuit intégré étant, bien entendu, maintenu sur un support à l'aplomb de la thermode.

Compte tenu des dimensions extrêmement faibles d'un circuit intégré, il est indispensable de l'aligner avec une grande précision par rapport à la thermode d'une part et à l'unité de circuit à laquelle il est destiné d'autre part. Dans la plupart des cas, le désalignement ne doit pas dépasser une erreur de 20 microns. Pour obtenir cette très grande précision, il est usuel d'employer des moyens optiques tels qu'un circuit de télévision et d'ajuster la position du circuit intégré par rapport à l'unité de circuit à l'aide de l'image prise par la caméra, par exemple en déplaçant manuellement le support du circuit intégré dans deux directions perpendiculaires. Ainsi, cette opération d'ajustement ne peut se faire que si le champ de la caméra dans le poste de soudage est dégagé, ce qui revient à déplacer latéralement la thermode avant et après l'alignement durant chaque cycle de travail.

En outre, ce cycle de travail comporte une opération de chargement du circuit intégré et on peut en arriver ainsi au total par circuit intégré à un cycle de travail de 4 secondes parmi lesquelles déjà une seconde est occupée pour le déplacement de la thermode dans le champ de la caméra et hors de celui-ci.

L'invention a pour but de fournir un procédé et une machine pour la mise en œuvre de la technique «I.L.B.» alliant la précision requise du soudage à un rythme de travail nettement supérieur à celui que l'on obtenait jusqu'à présent dans cette technique.

Elle a donc tout d'abord pour objet un procédé pour l'assemblage de circuits intégrés à des unités de circuit présentés selon une rangée longitudinale sur un ruban, par une opération de thermocompression ou de brasage des plots des circuits intégrés sur des bornes des unités de circuit respectives du ruban, procédé au cours duquel ce ruban est amené à défiler pas-à-pas dans un poste de soudage dans lequel l'assemblage a lieu après alignement précis de chaque circuit intégré sur une unité de circuit du ruban, ce procédé étant caractérisé en ce qu'on effectue simultanément sur des circuits intégrés distincts au moins une opération de chargement, une opération d'alignement et une opération de soudage, à l'aide d'un plateau de support de ces circuits monté rotatif dans le poste de soudage et déplaçable angulairement selon un mouvement pas-à-pas, un système de coordonnées polaires pouvant être défini par rapport à ce plateau de telle manière que l'emplacement d'un circuit intégré correspondant au soudage correct soit situé sur l'axe polaire de ce système avec un module $\underline{m}$ et que chaque pas du plateau corresponde à un déplacement d'argument $\underline{a}$ dans ce système, en ce que l'opération de chargement consiste à déposer chaque circuit intégré sur ledit plateau à un emplacement dont les coordonnées $[m+m_x; 3a+(a-a_x)]$ diffèrent légèrement d'un nombre entier d'arguments $\underline{a}$ et/ou dudit module $\underline{m}$ et en ce que l'opération d'alignement consiste à ramener chaque circuit intégré par glissement grâce à une simple opération de poussée effectuée dans un plan parallèle à celui du plateau, à un emplacement décalé exactement par rapport à l'emplacement de soudage d'un nombre entier d'arguments $\underline{a}$ et par rapport au centre du plateau d'une distance correspondant au module $\underline{m}$.

Il résulte tout d'abord de ces caractéristiques que la durée du cycle de travail peut être réduite par un facteur 2 c'est-à-dire pratiquement à celles des seules opérations de translation du ruban et de chargement du circuit, cette durée totale étant, par exemple de 2 secondes seulement. C'est en effet l'opération de chargement qui détermine alors cette durée, les autres opérations étant typiquement moins longues.

Ensuite, malgré le fait que l'alignement des circuits intégrés ne soit pas effectué dans le poste de soudage, on obtient la précision requise par la simplicité de l'opération d'alignement qui consiste à pousser le circuit à son emplacement correct sur le plateau. Celui-ci étant par ailleurs d'une rigidité mécanique considérable, les circuits une fois alignés ne peuvent plus s'écarter de leur position correcte jusqu'à ce qu'ils soient placés dans le poste de soudage. D'autre part, la précision d'alignement circuit intégré – unité de circuit dépend aussi de la tolérance de fabrication du film. Dans le cas où cette tolérance n'est pas suffisante pour réaliser l'opération d'«ILB», on peut facilement ajouter un système (p.ex. optique) permettant de réaligner selon convenance l'unité de circuit.

Enfin, les diverses positions du plateau atteintes à chaque pas de son mouvement, peuvent facilement être indexées tandis que, par ailleurs, les variations de la température ambiante n'ont qu'une influence négligeable sur le positionnement correct des circuits intégrés.

L'invention a également pour objet une machine pour la mise en œuvre du procédé tel que défini ci-dessus.

L'invention sera mieux comprise à la lecture de la description qui va suivre d'un exemple de réalisation de l'invention, faite en référence aux dessins annexés sur lesquels:

— la figure 1 est une représentation schématique en perspective d'une machine d'assemblage pour la mise en œuvre du procédé suivant l'invention;

— la figure 2 est une vue en plan schématique d'une partie de cette machine essentielle pour l'invention;

— la figure 3 représente en plan le plateau rotatif et son dispositif d'entraînement utilisés dans la machine à la figure 1;

— la figure 4 est une vue en coupe verticale du plateau, à une échelle double par rapport à la figure 3, la vue étant prise suivant la ligne IV–IV de la figure 3;

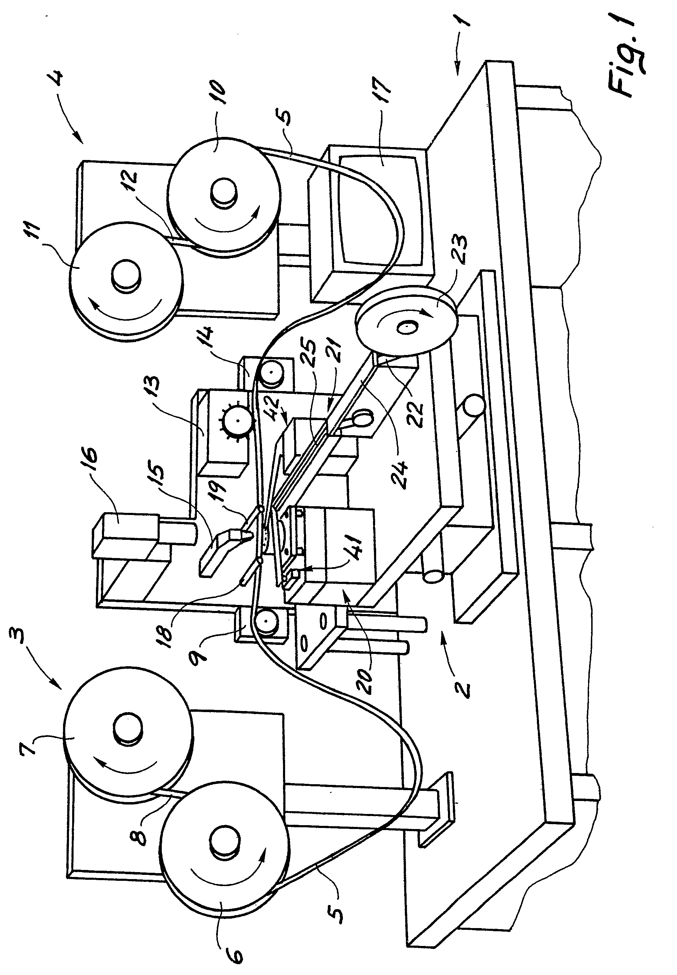

La vue en perspective de la figure 1 montre une machine d'assemblage de circuits intégrés qui comporte un bâti 1 sur lequel sont montées une unité de travail 2 placée au centre du bâti, une unité d'alimentation 3, ici placée à gauche de l'unité de travail 2 ainsi qu'une unité de réception 4 prévue du côté opposé.

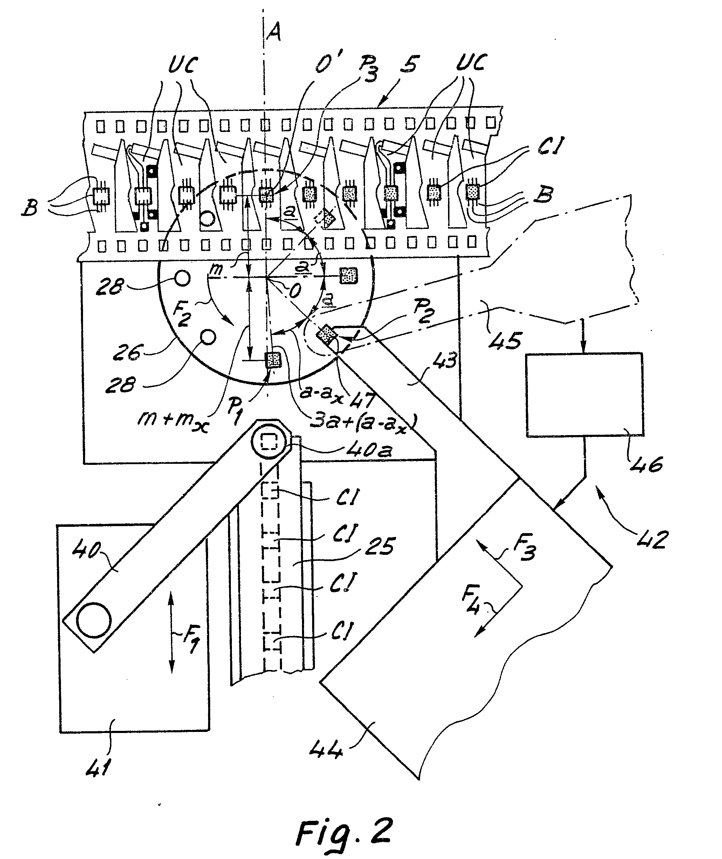

D'une façon connue en soi, la machine suivant l'invention utilise un ruban 5 se présentant sous la forme d'un film photographique, de 35 mm par exemple, muni de perforations normalisées (voir également la figure 2). Ce film circule entre l'unité d'alimentation 3 et l'unité de réception 4 en passant par l'unité de travail 2 où les circuits intégrés y sont fixés. L'unité d'alimentation comporte donc une bobine débitrice 6 comportant la réserve de film, une bobine 7 de réception d'une bande de protection 8 de ce film et des moyens 9 de guidage et de mise sous tension. L'unité de réception comprend une bobine d'enroulement 10 du film fini et une bobine 11 d'où est déroulée une bande de protection 12 qui est destinée à s'insérer entre les spires du film sur la bobine 10.

Le film 5 est entraîné pas-à-pas par un dispositif moteur 13 suivi d'un guide 14.

Une thermode 15 est disposée dans l'unité de travail 2 de manière à pouvoir effectuer non seulement un mouvement vertical pour effectuer l'opération de thermo-compression ou de brasage proprement dite, mais également un mouvement d'escamotage vers l'arrière. Ce dernier mouvement, qui n'est utile que pour le réglage de la machine, est destiné à dégager le champ d'une caméra de télévision 16 située au-dessus de cet outil de soudage, caméra qui forme l'image de la zone de travail de la machine sur un écran de télévision 17. Bien entendu, ce montage peut également être exploité pour le contrôle du travail effectué.

Le film 5 passe dans l'unité de travail 2 sur des guides 18 et 19 situés de part et d'autre d'un support 20 de circuits intégrés dans lequel est incorporée l'invention.

Avant de décrire ce support en détail, il est utile de signaler que les circuits intégrés sont fournis à l'unité de travail 2 à l'aide d'un dispositif de chargement 21. Ce dispositif peut être réalisé en partie conformément à la demande de brevet français 82 19 478 déposée le 18 novembre 1982. Il suffit de rappeler ici que ce dispositif de chargement utilise une bande adhésive 22 sur laquelle sont collés des circuits intégrés préalablement vérifiés. Les circuits intégrés sont collés sur cette bande à partir des plaquettes de silicium après un test de bon fonctionnement. La bande 22 est déroulée d'une bobine 23 et passe sur un organe de séparation 24 à partir duquel les circuits intégrés sont déposés dans un couloir 25 qui peut éventuellement être vibrant et qui constitue en même temps un réservoir tampon des circuits intégrés à partir duquel ceux-ci sont disposés sur le support 20.

On va maintenant examiner la figure 2 en décrivant tout d'abord plus en détail un exemple de film pouvant être traité dans la machine suivant l'invention.

Comme représenté, des unités de circuit UC sont réalisées dans le film 5 en étant alignées dans le sens longitudinal et chaque unité doit recevoir un circuit intégré CI. A cet effet, chaque unité de circuit UC comporte un certain nombre de bornes B qui sont respectivement destinées à être connectées par thermo-compression ou brasage à des plots correspondants (non représentés sur les dessins) des circuits intégrés, selon une technique qui est parfaitement connue. Bien entendu, l'invention ne se limite aucunement à quelque unité de circuit que ce soit, celle-ci pouvant être un simple ensemble de conducteurs ou bien être un ensemble plus évolué comportant déjà un ou plusieurs composants de circuit électriques ou électroniques. Par exemple, si le procédé de l'invention est utilisé dans le domaine de l'horlogerie, chaque unité de circuit UC peut déjà être munie d'une configuration de conducteurs, à laquelle sont raccordés le quartz et d'autres organes analogues. Il est à noter que sur la figure 2, seulement deux unités de circuit UC ont été représentées avec leurs conducteurs, ceci pour ne pas trop charger le dessin.

L'opération qui vient brièvement d'être décrite, est connue sous la dénomination «Inner Lead Bonding» et ne présente en soi aucune originalité. De même, la thermode de soudage 15 (figure 1) présente une forme classique, étant entendu qu'il est conformé pour pouvoir appliquer simultanément une certaine quantité de chaleur et une certaine valeur de pression sur toutes les superpositions d'une borne et d'un plot au cours de l'assemblage.

Il est à signaler également que l'opération ainsi effectuée assure non seulement le contact électrique du circuit intégré avec l'unité de circuit associée, mais encore leur assemblage, et par voie de conséquence la solidarisation avec le film 5.

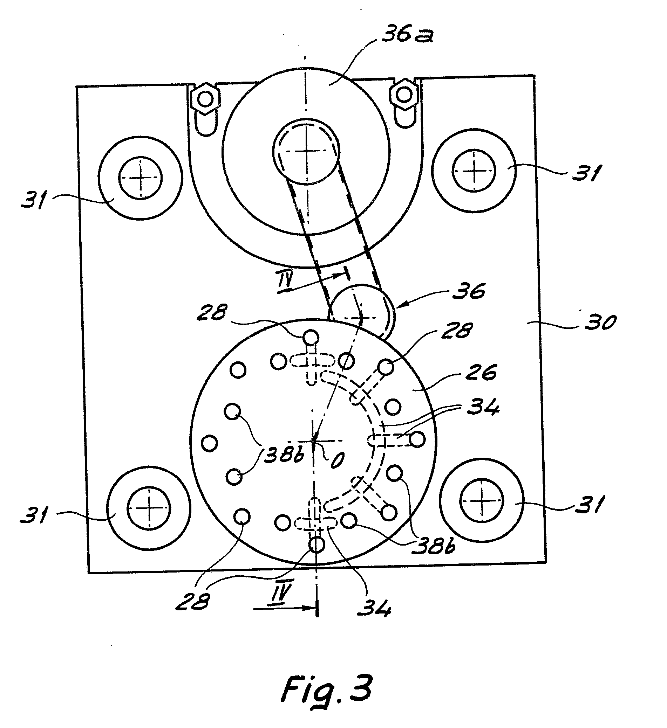

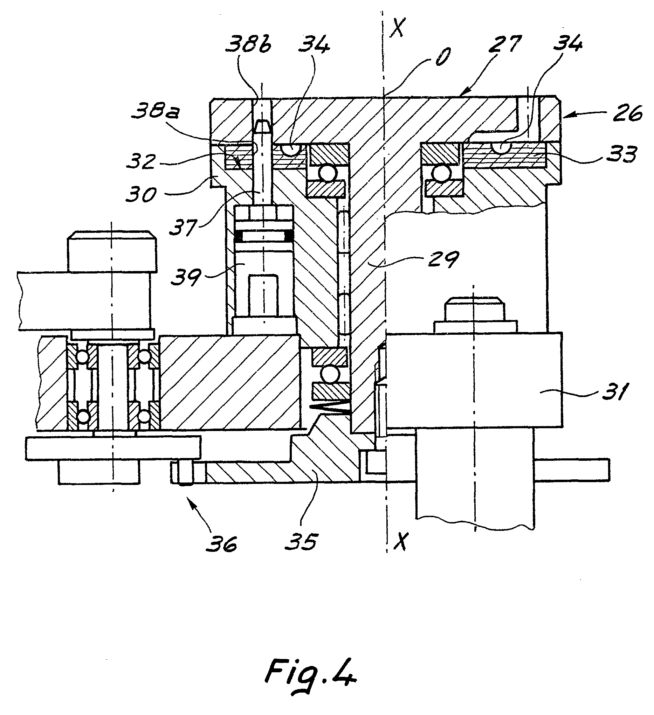

Conformément à l'une des caractéristiques essentielles de l'invention, le support 20 de circuits intégrés est réalisé sous la forme d'un plateau circulaire 26 (voir également les figures 3 et 4) qui est monté rotatif autour d'un axe vertical X–X définissant à la surface 27 de ce plateau un centre 0.

La surface 27 est plane et de préférence rectifiée avec une précision élevée.

Si on considère que le point 0 est le pôle d'un système de coordonnées polaires d'axe polaire 0A, il est fait en sorte que l'axe vertical de référence 0' défini par la thermode et par rapport auquel chaque circuit intégré CI doit être centré lors du soudage, se situe à une distance $m$ appelée module. Lorsque le circuit intégré est correctement centré sur cet axe 0', on admet que chaque borne B d'une unité de circuit UC se trouve exactement à l'aplomb d'un plot correspondant du circuit moyennant quoi le soudage peut être effectué avec la précision souhaitée. On rappelle que l'erreur d'alignement doit être inférieure à 20 microns, à défaut de quoi la connexion ne sera pas satisfaisante. Pour obtenir cette précision d'alignement, on ajoutera dans la plupart des cas un système d'alignement du film permettant de compenser les tolérances de fabrication de celui-ci.

Dans l'exemple représenté, le plateau comporte huit emplacements décalés angulairement de 45° les uns des autres, c'est-à-dire d'un argument $a$ dans le système de coordonnées que l'on vient de définir. Ces emplacements sont matérialisés par des trous 28 de forme circulaire percés dans le plateau avec leur centre écartés du centre de la surface 27 d'une distance qui est égale au module $m$.

La figure 4 montre que le plateau 26 est pourvu d'une broche centrale 29 qui s'étend vers le bas à partir de sa surface inférieure et qui est montée à rotation dans un châssis 30 monté sur quatre colonnettes 31. Ce montage est réalisé de telle manière que l'ensemble du châssis 30 et du plateau 26 puisse se déplacer verticalement de manière à rapprocher ou à éloigner la surface 27 du plateau 26 de la thermode 15.

Dans la surface supérieure 32 du châssis 30 est logée une bague 33, réalisée en Teflon (marque déposée), bague qui est à son tour pourvue de creusures 34 servant de conduits d'aspiration d'air. Ces conduits communiquent d'une part avec une source à dépression (non représentée) et d'autre part, sélectivement, avec les trous 28. Par ailleurs, la broche 29 est solidaire en rotation de la croix 35 d'un mécanisme à croix de Malte 36 de construction classique entraînée par un moteur 36a et assurant le mouvement pas-à-pas du plateau 26. Dans l'exemple représenté, le plateau peut occuper huit positions distinctes, le mouvement étant effectué en synchronisme avec l'avancement pas-à-pas du film 5.

Enfin, le châssis 30 est pourvu d'un doigt d'indexage 37 destiné à pénétrer sélectivement dans des trous 38a et 38b percés respectivement dans la bague 33 et le plateau 26 pour fixer les huit positions de ce dernier. Ces trous ne sont pas représentés sur la figure 2.

Le doigt d'indexage 37 est actionné par un vérin 39 en synchronisme avec les mouvements du plateau 26 et du film 5.

Le dispositif de chargement 25 comporte un bras de chargement 40 fonctionnant par dépression et monté sur un chariot 41, mobile dans le plan horizontal dans la direction de la flèche $F_1$ de la figure 2. Le bras de chargement 40 est destiné à transférer un à un les circuits intégrés CI de la sortie du réservoir 25 vers la position de chargement du plateau 26, cette position étant indiquée par la référence $p_1$ sur la figure 2. Le bras de chargement est pourvu de préférence d'une tête 40a montée rotative autour d'un axe vertical et fonctionnant par aspiration d'air. Ainsi, au cours du transfert vers le plateau 26, chaque circuit intégré peut être positionné angulairement par rapport à son propre centre en étant tourné sélectivement de 90°, 180° ou 270° par exemple.

Vu dans le sens d'avancement du plateau 26 (indiqué par la flèche $F_2$ sur la figure 2), il est prévu un dispositif d'alignement 42 qui comporte un bras d'alignement 43 monté sur un chariot 44 qui est mobile en translation X–Y selon les flèches $F_3$ et $F_4$. Les mouvements du bras 43 sont commandés par un système de réglage automatique composé d'un détecteur opto-électronique 45, d'un circuit de commande 46 et d'un moteur de commande (non représenté) couplé au chariot 44. Dans l'exemple représenté, les emplacements de chargement et d'alignement sont décalés angulairement de la valeur de l'argument $a$ du système de coordonnées polaires. Il en résulte que dans le mode de réalisation représentée, seulement trois emplacements parmi les huit possibles du plateau 26 sont pourvus d'un outillage, les autres emplacements ne constituant que de simples positions d'attente. On remarquera également qu'au cours du transfert d'un circuit intégré CI sur le plateau 26, il est maintenu par aspiration de la dépression appliquée à la bague 33.

Conformément à l'invention, le chargement de chaque circuit intégré sur le plateau 26 est réalisé de manière que sa position ne corresponde pas exactement à celle que ce circuit doit occuper, après translation angulaire, dans le poste de soudage, c'est-à-dire sous la thermode 15. En d'autres termes, dans le système de coordonnées définies ci-dessus, le module de la position de chargement est différent du module $m$ de la position de soudage $p_3$, tandis que l'argument ne correspond pas à un multiple entier de l'argument $a$ défini par l'écartement angulaire entre les trous 28. Dans le mode de réalisation représenté, la position de chargement $p_1$ correspond à un module $m+m_x$ tandis que l'argument correspond à une valeur $3a+(a-a_x)$, étant entendu que $m_x$ et $a_x$ sont des valeurs très faibles, pouvant varier d'un circuit intégré à l'autre.

Dans ces conditions il est possible de corriger la position du circuit une fois chargé par simple glissement sur la surface 27 à l'aide du bras 43.

On notera que l'extrèmité de ce bras présente une découpe en forme de L 47 dont les bords sont destinés à venir en contact avec deux bords adjacents du circuit intégré. Pour obtenir l'alignement correct, il est nécessaire, compte tenu des imprécisions qui peuvent se présenter lors de la réalisation du circuit intégré en ce qui concerne ces bords latéraux, d'effectuer l'alignement optiquement sur un plot de connexion, ce qui est réalisé à l'aide du détecteur 45 et de sa boucle de réglage associée. Il est à noter que le détecteur optique 45 est de préférence celui réalisé par la société Ciposa, CH-2525 Le Landeron, sous la dénomination «Mini-Demo» type 102–0662. La boucle de réglage est conçue pour disposer chaque circuit intégré par rapport à une référence qui est rapportée à la position de soudage correcte. Dans le cas représenté, cette position a un module $m$ et un argument égal à $3a$, étant entendu que le bras d'alignement place le centre du circuit intégré exactement en coïncidence avec le point défini par ces coordonnées. De la sorte, le circuit intégré se trouve aligné sous la thermode 15 après trois pas du plateau 26.

Le cycle de travail de la machine qui vient d'être décrite se déroule de la façon suivante.

Les circuits intégrés CI sont successivement placés dans la position de chargement $p_1$ dont les coordonnées sont celles indiquées ci-dessus. Le circuit est maintenu sur le plateau par dépression. Pendant cette opération, le circuit intégré préalablement chargé est aligné au moyen du bras 43 et de la boucle de réglage composée du détecteur 45, du dispositif de commande 46 et du moteur d'entraînement du chariot 44. Simultanément, le circuit intégré qui était déjà transféré vers la position de soudage $p_3$ est soudé sur l'unité de circuit UC se présentant à cet instant sous la thermode 15.

Ce cycle étant terminé, le film 5 et le plateau 26 sont avancés d'un pas et les trois opérations décrites précédemment se répètent simultanément sur trois circuits intégrés se trouvant alors sur le plateau 26. Ainsi le cycle de travail se trouve être notablement raccourci par rapport à celui des machines de la technique antérieure dans lesquelles les trois opérations étaient effectuées les unes après les autres dans le poste de soudage.

**Revendications**

1. Procédé pour l'assemblage de circuits intégrés à des unités de circuit présentés selon une rangée longitudinale sur un ruban, par une opération de thermo-compression ou brasage des plots des circuits intégrés (CI) sur des bornes des unités de circuits (UC) respectives du ruban (5), procédé au cours duquel ce ruban (5) est amené à défiler pas-à-pas (2) dans un poste de soudage dans lequel l'assemblage a lieu après alignement précis de chaque circuit intégré (CI) sur une unité de circuit (UC) de ruban (5), ce procédé étant caractérisé en ce qu'on effectue simultanément sur des circuits intégrés distincts au moins une opération de chargement, une opération d'alignement et une opération de soudage, à l'aide d'un plateau de support (26) de ces circuits monté rotatif dans le poste de soudage (2) et déplaçable angulairement selon un mouvement pas-à-pas, un système

de coordonnées polaires (0,0A) pouvant être défini par rapport à ce plateau de telle manière que l'emplacement ($p_3$) d'un circuit intégré correspondant au soudage correct soit situé sur l'axe polaire (0A) de ce système avec un module $m$ et que chaque pas du plateau (26) corresponde à un déplacement d'argument $a$ dans ce système, en ce que l'opération de chargement consiste à déposer chaque circuit intégré (CI) sur ledit plateau (26) à un emplacement ($p_1$) dont les coordonnées $[m+m_x; 3a+(a-a_x)]$ diffèrent légèrement d'un nombre entier d'arguments $a$ et/ou dudit module $m$ et en ce que l'opération d'alignement consiste à ramener chaque circuit intégré (CI) par glissement grâce à une simple opération de poussée effectuée dans un plan parallèle à celui du plateau, à un emplacement décalé exactement par rapport à l'emplacement de soudage ($p_3$) d'un nombre entier d'arguments $a$ et par rapport au centre de plateau d'une distance correspondant au module $m$.

2. Procédé suivant la revendication 1 caractérisé en ce qu'au cours de l'opération d'alignement, on repère optiquement l'un des plots du circuit intégré (CI) par rapport à une référence rapportée à la position d'alignement correcte, et on commande le mouvement de glissement du circuit intégré jusqu'à annulation de l'erreur en module et en argument par rapport à ladite référence.

3. Procédé suivant l'une quelconque des revendications 1 et 2 caractérisé en ce que lors du chargement, on tourne chaque circuit intégré sur lui-même dans un plan parallèle à ses grandes faces et à celui du plateau (26), pour adapter sa position à celle qu'il doit occuper au cours du soudage dans le poste correspondant (2).

4. Machine pour la mise en œuvre du procédé suivant l'une quelconque des revendications 1 à 3 comprenant un poste de soudage (2) par thermo-compression ou brasage, un dispositif (3, 4, 13, 14) destiné à faire défiler pas-à-pas un ruban (5) portant les unités de circuit (UC) dans ledit poste de soudage, un dispositif de chargement (20) pour permettre la présentation un à un des circuits intégrés (CI) dans le poste de soudage à l'aplomb des unités de circuit respectives et un dispositif d'alignement (42) destiné avant chaque soudage à faire coïncider les plots d'un circuit intégré (CI) avec des bornes de connexion d'une unité de circuit (UC), un plateau (26) monté rotatif autour d'un axe vertical par rapport au poste de soudage (2), et des moyens (36) pour entraîner le plateau selon un mouvement pas-à-pas en synchronisme avec le mouvement dudit ruban (5), la machine étant caractérisée en ce que ledit plateau comprend au moins trois emplacements correspondant à autant de positions de travail ($p_1$, $p_2$, $p_3$) décalées angulairement sur une même circonférence et passant successivement à l'aplomb de l'outil de soudage (15) au cours du mouvement du plateau, ces positions étant respectivement desservies simultanément entre deux pas successifs du plateau par ledit dispositif de chargement, ledit dispositif d'alignement et ledit outil de soudage (15), en ce que ledit dispositif de chargement comporte un bras de transfert (40) capable de charger chaque circuit intégré sur le plateau à l'emplacement correspondant avec un décalage angulaire et radial [m+$m_x$, 3a+(a-$a_x$)] par rapport à la position que ce circuit doit occuper lorsque cet emplacement s'arrête sous l'outil de soudage, et en ce que ledit dispositif d'alignement (42) comporte un bras poussoir (43) mobile dans un plan parallèle à la surface (27) du plateau pour annuler ledit décalage angulaire et radial du circuit intégré par glissement de celui-ci à l'emplacement correspondant, pour que ce circuit soit présenté correctement sous l'outil de soudage (15).

5. Machine suivant la revendication 4 caractérisée en ce que ledit bras poussoir (43) comporte une extrémité (47) présentant une découpe en forme de L dont les bords sont destinés à venir en contact avec deux bords adjacents latéraux des circuits intégrés au cours de l'opération d'alignement.

6. Machine suivant l'une quelconque des revendications 4 et 5 caractérisée en ce que ledit dispositif d'alignement comporte une boucle de réglage de la position du bras poussoir (42), cette boucle comprenant un détecteur optique (45) destiné à détecter la position d'un plot dudit circuit intégré ainsi que des moyens (46, 44) destinés à commander le mouvement dudit bras en fonction de l'écart radial et angulaire dudit plot par rapport à la position correcte de soudage du circuit intégré (CI).

**Patentansprüche**

1. Verfahren zum Zusammenfügen integrierter Schaltkreise mit Schaltungseinheiten, die in Längsrichtung aufeinanderfolgend auf einem Band präsentiert werden, mittels einer Thermokompressionsoperation oder Verlötung der Kontaktstücke der integrierten Schaltkreise (CI) mit den Anschlüssen der Schaltungseinheiten (CU) des Bandes (5), bei welchem Verfahren dieses Band (5) schrittweise (2) eine Lötstation durchläuft, in der das Zusammenfügen erfolgt, nachdem jeder integrierte Schaltkreis (CI) bezüglich einer Schaltungseinheit (CU) des Bandes (5) präzis ausgerichtet worden ist, welches Verfahren dadurch gekennzeichnet ist, dass man gleichzeitig an einzelnen integrierten Schaltkreisen mindestens einen Arbeitsgang der Beladung, einen Arbeitsgang des Ausrichtens und einen Lötarbeitsgang durchführt mittels einer Schaltkreis-Supportplatte (26), die drehbeweglich in der Lötstation (2) angeordnet und schrittweise winkelbeweglich ist, wobei ein System von Polarkoordinaten (0, OA) bezüglich dieser Platte derart definiert werden kann, dass die Position ($P_3$) eines integrierten Schaltkreises entsprechend der korrekten Lötung in der polaren Achse (OA) dieses Systems liegt mit einem Modul $m$ und dass jeder Schritt der Platte (26) einer Verlagerung um das Argument $a$ in diesem System entspricht, dass der Arbeitsgang der Beladung aus dem Plazieren jedes integrierten Schaltkreises (CI) auf der Platte (26) an einer Stelle ($P_1$) besteht, deren Koordinaten (m+$m_x$; 3a+(a-$a_x$)) etwas von einer ganzen Zahl von Argumenten $a$ und/oder dem Modul $m$

abweichen, und dass der Arbeitsgang des Ausrichtens darin besteht, jeden integrierten Schaltkreis (CI) mittels Gleitbewegung dank einer einfachen in einer Ebene parallel zu der der Platte ausgeführten Schiebeoperation an eine Stelle zu verlagern, die bezüglich der Lötstelle ($P_3$) um eine ganze Zahl von Argumenten $a$ versetzt ist und bezüglich des Plattenzentrums einen dem Modul $m$ entsprechenden Abstand aufweist.

2. Verfahren nach Anspruch 1, dadurch gekennzeichnet, dass man während des Ausrichtarbeitsganges optisch eines der Kontaktstücke des integrierten Schaltkreises (CI) relativ zu einer Referenz ausrichtet, bezogen auf die Position der korrekten Ausrichtung, und dass man die Gleitbewegung des integrierten Schaltkreises bis zur Annulierung des Moduls und Argumentfehlers bezüglich der genannten Referenz steuert.

3. Verfahren nach einem der Ansprüche 1 und 2, dadurch gekennzeichnet, dass während der Beladung jeder integrierte Schaltkreis um sich selbst in einer Ebene parallel zu seinen grossen Flächen und der der Platte (26) verdreht wird zum Anpassen seiner Position an diejenige, die er während des Lötens in der entsprechenden Station (2) einnehmen muss.

4. Maschine zum Ausführen des Verfahrens nach einem der Ansprüche 1 bis 3, umfassend eine Lötstation (2) mittels Thermokompression oder Hartlötung, eine Vorrichtung (3, 4, 13, 14) bestimmt zum schrittweisen Durchführen eines die Schaltungseinheiten (UC) tragenden Bandes (5) durch die Lötstation, eine Beladevorrichtung (20) zum Ermöglichen der Präsentation der integrierten Schaltkreise (CI) nacheinander an der Lötstation in Ausfluchtung mit den jeweiligen Schaltungseinheiten und eine Ausrichtvorrichtung (42) bestimmt dazu, vor jedem Verlöten die Kontaktstücke eines integrierten Schaltkreises(CI) mit den Anschlüssen einer Schaltungseinheit (UC) zur Koinzidenz zu bringen, mit einer Platte (26), die um eine Vertikalachse relativ zur Lötstation (2) drehbeweglich ist und mit Mitteln (36) zum Antrieb der Platte in einer Schrittbewegung synchron mit der Bewegung des genannen Bandes (5), welche Maschine dadurch gekennzeichnet ist, dass die Platte mindestens drei Stellen aufweist entsprechend den Arbeitspositionen ($P_1$, $P_2$, $P_3$), die in Winkelrichtung auf ein und demselben Umfang versetzt angeordnet sind und nacheinander das Lötwerkzeug (15) während der Bewegung der Platte passieren, welche Positionen jeweils gleichzeitig zwischen zwei aufeinanderfolgenden Schritten der Platte durch die genannte Beladevorrichtung, die genannte Ausrichtvorrichtung und das genannte Lötwerkzeug (15) bedient werden, dass die genannte Ladevorrichtung einen Transferarm (40) umfasst, ausgebildet zum Laden jedes integrierten Schaltkreises auf die Platte an einer Stelle, die mit Radial- und Winkelversatz (m+$m_x$, 3a+(a–$a_x$)) der Position entspricht, welche dieser Schaltkreis einnehmen muss, wenn diese Stelle unter dem Lötwerkzeug zum Stillstand kommt und dass die genannte Ausrichtvorrichtung (42) einen Schiebearm (43) umfasst, der in einer Ebene parallel zur Oberfläche (27) der Platte beweglich ist zum Annulieren des genannten Radial- und Winkelversatzes des integrierten Schaltkreises durch Gleitbewegung des letzteren an die entsprechende Stelle derart, dass dieser Schaltkreis korrekt unter dem Lötwerkzeug (15) präsentiert wird.

5. Maschine nach Anspruch 4, dadurch gekennzeichnet, dass der genannte Schiebearm (43) ein Ende (47) mit einem L-förmigen Ausschnitt aufweist, dessen Kanten dazu bestimmt sind, in Kontakt mit zwei angrenzenden Seitenkanten des integrierten Schaltkreises während des Ausrichtarbeitsganges zu treten.

6. Maschine nach einem der Ansprüche 4 und 5, dadurch gekennzeichnet, dass die genannte Ausrichtvorrichtung eine Regelschleife für die Position des Schiebearms (43) umfasst, welche Regelschleife einen optischen Detektor (45) umfasst, bestimmt zum Erfassen der Position eines Kontaktstücks des integrierten Schaltkreises sowie Mittel (46, 44), die dazu bestimmt sind, die Bewegung des Armes zu steuern in Abhängigkeit von der Radial- und Winkelabweichung des Kontaktstücks relativ zu der korrekten Position für das Verlöten des integrierten Schaltkreises (CI).

## Claims

1. A process for the assembly of integrated circuits to circuit units presented in a row lengthwise on a tape, by an operation of thermal compression or brazing of the integrated circuit (IC) studs onto terminals of the respective circuit units (CU) of the tape (5), in the course of which process this tape (5) is caused to pass stepwise (2) into a welding station wherein the assembly takes place after precise alignment of each integrated circuit (IC) on a circuit unit (CU) of the tape (5), this process being characterized in that at least one loading operation, one aligning operation and one welding operation are executed with the aid of a support platform (26) of these circuits, fitted rotatably into the welding station (2) and displaceable at an angle according to a stepwise movement, a system of polar coordinates (0, 0A) being definable in relation to this platform, such that the location (p₃) of an integrated circuit corresponding to the correct welding is situated on the polar axis (OA) of this system with a module $m$ and that each step of the platform (26) corresponds to a displacement of the argument $a$ in this system, in that the loading operation consists of placing each integrated circuit (IC) on the said platform (26) at a location (p₁) for which the coordinates $[m+m_x; 3a+(a-a_x)]$ differ slightly from a whole number of arguments $a$ and/or from the said module $m$; and in that the operation of alignment consists in bringing each integrated circuit (IC) by sliding by means of a simple pushing operation executed in a plane parallel to that of the platform, into a location separated precisely in relation to the welding location (p₃) of a whole number of arguments $a$ and in relation to the centre of the platform at a distance corresponding to the module $m$.

2. A process according to claim 1 characterized in that in the course of the alignment operation one of the studs of the integrated circuit (IC) is registered optically in relation to a reference related to the correct position of alignment and the movement of sliding of the integrated circuit is controlled until the error is cancelled in the module and argument in relation to said reference.

3. A process according to either claim 1 or claim 2 characterized in that on loading, each integrated circuit is turned on itself in a plane parallel to its main faces and to that of the platform (26), to adjust its position to that which it should occupy during welding in the corresponding station (2).

4. An apparatus for carrying out the process set out in any one of claims 1 to 3, comprising a welding station (2) by thermal compression or brazing, a device (3, 4, 13, 14) intended to cause a tape (5) carrying circuit units (CU) to pass stepwise into the said welding station, a loading device (20) to permit the presentation one by one of the integrated circuits (IC) in the welding station normal to the respective circuit units and an aligning device (42) designed before each welding to cause the studs of an integrated circuit (IC) to coincide with the connecting terminals of a circuit unit (CU), a platform (26) attached rotatably about a vertical axis in relation to the welding station (2) and means (36) for driving the platform in a stepwise movement synchronously with the movement of the said tape (5), the apparatus being characterized in that the said platform comprises at least three locations corresponding to as many operating stations, (p₁, p₂, p₃) offset at an angle on the same circumference and passing in succession normal to the soldering tool (15) in the course of the movement of the platform, these positions respectively being cleared simultaneously between two successive steps of the platform by the said loading device, the said aligning device and the said welding tool (15), in that the said loading device has a transfer arm (40) capable of loading each integrated circuit onto the platform at the corresponding location with an angular and radial offsetting $[m+m_x, 3a+(a-a_x)]$ in relation to the position which this circuit should occupy when this location halts under the welding tool, and in that the said aligning device (42) has a push arm (43) mobile in a plane parallel to the surface (27) of the platform to cancel the said angular and radial offsetting of the integrated circuit by sliding said circuit to the corresponding location, so that this circuit is presented correctly under the welding tool (15).

5. An apparatus according to claim 4 characterized in that the said push arm (43) comprises an end (47) having an L-shaped cut-out, the edges whereof are intended to come into contact with two adjacent side edges of the integrated circuits in the course of the alignment operation.

6. An apparatus according to either claim 4 or claim 5, characterized in that the said alignment device comprises a loop for adjusting the position of the push arm (42), this loop comprising an optical detector (45) designed to detect the position of a contact of the said integrated circuit, as well as means (46, 44) designed to control the movement of the said arm as a function of the radial and angular distance of said stud in relation to the correct welding position of the integrated cir- cuit (IC).

Fig.1

EP 0 180 172 B1

Fig. 2

3/4

Fig.3

4/4

Fig.4